# EUROPEAN PATENT APPLICATION

(11) **EP 2 246 667 A1**
(43) Date of publication of application: **03.11.2010**
(21) Application number: 09158908.5
(22) Date of filing: 28.04.2009
(51) Int. Cl.: G01D 4/00, G01R 11/24

(54) **Consumption meter with optical sealing system**

(71) Applicant: KAMSTRUP A/S, 8660 Skanderborg (DK)
(72) Inventor: Nielsen, Søren Tønnes, DK-8355, Solbjerg (DK)
(74) Representative: Plougmann & Vingtoft A/S

(57) **Abstract**

A consumption meter, for measuring a consumed quantity, e.g. for charging purposes. The meter includes a measurement circuit MC and a calculator circuit of which at least one, e.g. both, is/are housed inside a casing CS. The meter further includes a sealing system including a light sensitive component LSC, e.g. a photo diode, and a light reducing element LRE, e.g. a self-adhesive label, arranged to prevent light incidence on the light sensitive component LSC, when the light reducing element LRE is in a sealing position. Thus, with such sealing system it is possible to discriminate between a sealed and an un-sealed condition of the meter. It is possible to electronically store and/or remotely communicate any detected un-sealed events. Especially, the light sensitive component LSC is also used as optical communication interface for reading and/or software re-configuration of the meter. Hereby, the light reducing element LRE is used to seal the meter against optical re-configuration, since its presence hinders use of the optical interface. If placed under a transparent and at the same time a removable part of the casing CS, then the light sensitive component LSC can also detect opening of the casing CS. Hereby, optical sealing can eliminate the need for mechanical seals.

## Description

### FIELD OF THE INVENTION

The invention relates to the field of consumption meter, such as a consumption meter for measuring an amount of electricity, heat, cooling, gas or water. In particular the invention provides a consumption meter with an optical sealing system which serves to detect tampering and attempts to re-program the meter.

### BACKGROUND OF THE INVENTION

A consumption meter for billing purposes can be seen as two parts: a measuring part and an additional part that includes different functionalities. The measuring part is being verified by an accredited testing facility for billing purposes, and is sealed after being verified. The sealing is most often of a mechanical type, such as a wire with a lead seal locking the ends of the wire, a kind of sealing wax is used or a label is used for void sealing.

The additional part of a consumption meter can be sealed by either the manufacturer or the utility that installs the meter at the end customer, since this part can include power supply such as batteries, communication means such as a radio transmitter or a power line communication module or other functionalities such as a gas detector. Most often this consumption meter part requires software configuring to adopt the different functionalities.

Software configuration is however an issue that involves both the measuring part and the additional part of the consumption meter, since the functionalities verified by the testing facility may include setting zero of the measuring range and other issues such as some configurations of the display settings. This part of the software configuration is referred to as the legal part of the configuration, since it is affecting the basic measuring or displaying functionality of the consumption meter, whereas the non-legal part includes adoption of additional functionalities as well as other issues such as clock setting.

The non-legal part of the software configuration can often be done by means of an optical communication service that is provided on most consumption meters, by using a manufacturer specified device, an optical communication port, capable for this communication. The utility is using this during installation and servicing, the main advantage being that no disassembly has to be performed during the configuration or reconfiguration. The optical communication port can also be used by the consumer, by whom the meter is installed, to read and transfer data to e. g. a web interface for surveillance purposes. This service requires a reader that is mounted at the optical interface and a signal transmitter, and is a service offered by the utility.

The legal software part is however protected by the seal installed by the testing facility, and requires disassembly since often of mechanical type. In particular when periodical re-verification of the consumption meter is performed this can be of disadvantage. Consumption meters are in general reliable and most often passes the re-verification showing little effect of wear and tear, however some issues such as zero setting could be subject of adjusting.

The typically used types of wire seals are time consuming to maintain and re-configure, since they need manual operation of service persons both removal of the seal before dismantling, and mounting of a new seal after re-assembling the meter. Further, mechanical types of seals often require special features in the casing parts of the meter, such as holes through the parts of the casing that are to be sealed together. Such special features increase the complexity of the meter and thus raise the total manufacturing costs.

### SUMMARY OF THE INVENTION

In view of the above, it may be seen as an object of the present invention to provide a consumption meter with improved maintenance speed and which is still suited for low cost manufacturing.

The invention provides a consumption meter a consumption meter arranged to measure a consumed quantity of a physical entity, the meter comprising
- a measurement circuit arranged to perform a measurement of a physical parameter related to the physical entity and to generate measurement data accordingly,
- a calculator circuit arranged to calculate a quantity value representing the consumed quantity in response to the measurement data,
- a casing housing at least one of the measurement circuit and the calculator circuit, such as housing both of the measurement circuit and the calculator circuit, and
- a sealing system arranged in connection with the casing, wherein the sealing system comprises
   - a light sensitive component, such as a photo diode placed behind a transparent part of the casing, and
   - a light reducing element, such as a self-adhesive label, arranged to prevent light incidence on the light sensitive component, when the light reducing element is in a sealing position.

Such consumption meter is quicker to maintain since a mechanical seal can be eliminated, since this mechanical seal is replaced by an optical sealing system, thereby speeding up maintenance and updating of the meter. This helps saving costs involved in service and maintenance of the meter. Further, special mechanical features on the casing suited for mounting of a mechanical can be eliminated, thus serving to simplify the casing.

The sealing system according to the invention is suited for protection of and easy accessibility of software downloading to the meter via an optical communication port, as will be described in connection with preferred embodiments.

With the sealing system according to the invention, it is possible to electronically detect any attempt on re-configuration or tampering of the meter. Hereby, it is possible for the meter to communicate, e.g. via wireless Radio Frequency communication, that tampering has occurred, and thus tampering can be quickly revealed by the utility, and a service person can be called to repair or replace the meter.

In one embodiment, the light sensitive component is an optical communication device arranged for communicating with the meter, such as an optical communication device arranged for programming or reading the meter. In such embodiment, the function of the light sensitive transducer of an existing optical communication port in the meter can be utilized also for sealing purposes, thus saving an additional light sensitive component. Further, by using the optical communication device already present, electrical connections to a suitable processor in the meter is present, and thereby the sealing system can be implemented as an add-on to existing meter in the form of a software update and a light reducing element, e.g. in the form of a self-adhesive label shaped to cover the optical communication port.

In another embodiment, the light sensitive component is a light sensitive component dedicated for sealing purposes, i.e. a component separate from a possible optical communication port in the meter. Such embodiment is of course suited for meters without an optical communication port. However, it may also be used for meters comprising an optical communication device, namely in the form of a light sensitive component arranged in relation to the optical communication device such that the light reducing element prevents light incidence on the light sensitive component only, while the optical communication device is un-blocked and thus still available for communication in a sealed state, when the light reducing element is in the sealing position.

In a preferred embodiment, the sealing system comprises an electronic sealing circuit connected to the light sensitive component, and wherein the electronic sealing circuit is arranged to detect if the light reducing element is in the sealing position. Especially, the electronic sealing circuit may be arranged to generate an electric signal according to the detection. The electronic sealing circuit may be partly of fully integrated with other circuitry of the meter, especially the sealing circuit may be partly integrated with the main processor of the meter. The electronic sealing circuit may be arranged to initiate at least one action in response to detecting that the light reducing element is not in the sealing position. Especially, the meter may comprise a communication module connected to the electronic sealing circuit, and wherein at least one action comprises transmitting an external alarm signal by means of the communication module. Hereby, the utility can be quickly informed of any tampering attempt, and suitable remedies can be initiated, e.g. automatically. Additionally or alternatively, the at least one action may comprise storing in a memory data indicating the detection that the light reducing element is not in the sealing position, such as storing time and date of such event. Hereby, tampering attempts can be identified on request to the meter. In case the consumption meter is an electricity meter including a power switch arranged to switch off the electric power supply to the consumer, the at least one action may additionally or alternatively comprise activating the power switch to switch off the electric power supply to the consumer, in case a non-sealing condition is detected.

In one embodiment, the light sensitive component is placed within the casing, preferably behind a transparent cover part of the casing or in an opening of the casing, and wherein the light reducing element is a self-adhesive label arranged to at least partly cover the transparent part of casing.

In some embodiments, the light sensitive component is arranged such that it can detect incident light in both of the cases: the light reducing element being removed from the sealing position, and the casing being opened. Hereby, it is possible to utilize the light sensitive component for detection of both optical re-configuration and of tampering attempts where the casing is opened. Especially, the light sensitive component may be arranged behind a removable cover of the casing, such as behind a transparent part of the removable cover of the casing. Even more specifically, the light sensitive component maybe arranged behind the same part of the removable cover of the casing as an optical communication device of the meter.

In one embodiment, the sealing system comprises a second light sensitive component arranged inside the casing, and wherein at least part of the casing serves to reduce light incidence on the second light sensitive component, when the casing is closed. Hereby, it is possible to use the first light sensitive component to detect attempts to re-configure the meter by using an optical communication port/device of the meter, whereas the second light sensitive component, e.g. a photo diode, may be placed inside the casing such that it is exposed to daylight only when the casing is opened. Hereby, the second light sensitive component is dedicated detection of mechanical tampering of the meter.

In simple embodiments, the sealing system is arranged to detect a level of light exposure in order to determine if the light reducing element is in a sealing position or not. Typically, the light exposure to be determined will be daylight and/or light from electric light, and thus any type of photo diode or photo resistor will be sufficient to serve as a light sensitive component. Especially, the light sensitive component may be arranged to sense visible light only, however the light sensitive component may alternatively be arranged to sense light outside a visible light frequency range, or more alternatively be arranged to sense light outside a visible light frequency range only.

The consumption meter according to the invention may be an electricity meter, a heat meter, a cooling meter, a water meter, or a gas meter. The invention is advantageous for all kind of consumption meters, especially consumption meters for charging purposes including legally certified software.

It is appreciated that two or more of the mentioned embodiments can advantageously be combined.

### BRIEF DESCRIPTION OF THE DRAWING

Embodiments of the invention will be described, by way of example only, with reference to the drawing.

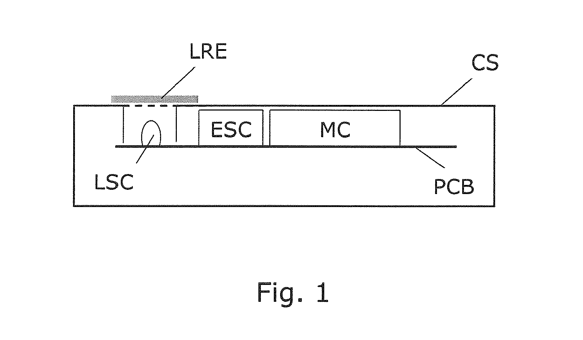

Fig. 1 illustrates a sketch of a consumption meter embodiment with a sealing system comprising a photo diode and a self-adhesive label.

### DESCRIPTION OF EMBODIMENTS

Fig. 1 shows a sketch of selected components of a consumption meter embodiment according to the invention. The consumption meter includes casing CS with a printed circuit board PCB contained therein. The PCB has a measurement circuit MC disposed thereon, serving to perform physical measurements related to the consumed quantity to measure. Further, the PCB holds a light sensitive component LSC, preferably in the form of a photo diode soldered directly to the PCB. Via the PCB, the light sensitive component LSC is connected to an electronic sealing circuit ESC capable of receiving an electric signal from the light sensitive component LSC and generate in response, an electric signal indicating whether the consumption meter, e.g. since last reset, has been exposed to an unsealed event. Preferably, the electronic sealing circuit ESC can store time and date of such unsealed event in a memory, and thus allowing later reading, either remotely or locally on the meter.

The light sensitive component LSC is placed in relation to the casing CS, behind a transparent part, at least translucent part, of the casing CS, indicated in Fig. 1 with a dashed line. Thus, without any light reducing cover, the light sensitive component is visible from outside, and thus exposed to the light intensity, e.g. from daylight and/or electric light, outside the meter casing CS. To cover the transparent part of the casing CS in a sealed condition, a light reducing element LRE is arranged on the outer surface of this transparent part of the casing CS. Preferably, the light reducing element LRE is a self-adhesive label with a texture that at least significantly reduces incident daylight, such that the light reducing element LRE, when in place or not, results in a detectable difference in intensity of light sensed by the light sensitive component LSC. Preferably, the light sensitive component LSC is capable of sensing such difference in light intensity also in case the meter is placed in a rather dark environment with a low background light intensity.

To ensure that the light sensitive component LSC is not exposed to any false light, i.e. light not related to removal of the light reducing element LRE, a non-transparent canal may be placed around the light sensitive component LSC, hereby serving to ensure that only light through the transparent part of the casing CS can reach the light sensitive component LSC. In Fig. 1 two vertical lines indicate such canal which can be an integrated part of the casing CS.

In basic, the idea behind the sealing system is that the light sensitive component LSC and the electronic sealing circuit is capable of discriminating between two conditions of the meter: 1) a sealed condition, namely when the light reducing element LRE is in a sealed position and thus blocks light from outside reaching the light sensitive component LSC, and 2) an un-sealed condition, namely when the light reducing element LRE is removed, misplaced, partly broken etc., thus allowing light from outside to reach the light sensitive component.

As already mentioned, the light sensitive component LSC may be the same component which is used also as an optical communication port or interface for the consumption meter, e.g. a typical light sensitive component LSC for such purpose, namely a light sensitive component arranged for sensing of infrared light. Thus, in such cases the light reducing element LRE has the function of blocking the consumption meter from any use of the optical communication interface, and at the same time the light reducing element LRE forms part of a detection system which allows detection of the meter entering an un-sealed condition, namely when the light reducing element LRE is removed and thus allows access to the optical communication port. Removing the light reducing element LRE, e.g. a self-adhesive label, should thus preferably make access to the legal software possible through the optical communication device used for re-configuration for the non-legal part, as well as an internal registration of the label removal should be communicated to the meter owning utility if communication means are present and/or saved in the meter for later communication.

In the illustrated embodiment on Fig. 1, the upper part of the casing CS, i.e. a part including the transparent part of the casing CS is removable, such as fastened to a lower part of the casing by means of a number of screws. If the PCB is fastened to the lower part of the casing CS, then removing the upper part of the casing CS will expose the light sensitive component LSC to daylight and thus allow detection of the opening of the casing CS. Hereby, the sealing system also serves as a mechanical tampering sealing, thus eliminating the need for a traditional type of wire seal or lacquer sealing of the casing CS fastening screws. Especially, this combined sealing function can be obtained by the light sensitive component LSC serving also as optical transducer of an optical communication interface of the meter. Hereby, also at least part of, e.g. all of, the electronic sealing circuits can be shared with the optical communication interface, and thus the sealing system according to the invention can be implemented or integrated easily in an existing consumption meter design. The need for mechanical sealing in the form of wire seals etc. can be eliminated, thus saving time during service of the meter.

As mentioned, the light reducing element LRE is preferably a self-adhesive label. However, in principle any simple cover with a sufficient light reducing effect can be used as light reducing element LRE, preferably in the form of a cover which is suited to provide a fixed position when being in the sealing position. E.g. in the form of a piece of plastics shaped to fit one or more mechanical features provided on the casing CS, e.g. a recess, an opening or the like. Specific alternatives are: a cap to fit an opening in the casing CS, a sheet of plastics or other suitable material suited to fit a recess in the form of a rail on the casing CS, e.g. with a locking mechanism in the form of corresponding part of the casing CS and the light reducing element LRE arranged for mutual engagement so as to provide a locking mechanism when the light reducing element LRE is in a sealing position.

To sum up, the invention provides a consumption meter, for measuring a consumed quantity, e.g. for charging purposes. The meter includes a measurement circuit MC and a calculator circuit of which at least one, e.g. both, is/are housed inside a casing CS. The meter further includes a sealing system including a light sensitive component LSC, e.g. a photo diode, and a light reducing element LRE, e.g. a self-adhesive label, arranged to prevent light incidence on the light sensitive component LSC, when the light reducing element LRE is in a sealing position. Thus, with such sealing system it is possible to discriminate between a sealed and an un-sealed condition of the meter. It is possible to electronically store and/or remotely communicate any detected un-sealed events. Especially, the light sensitive component LSC is also used as optical communication interface for reading and/or software re-configuration of the meter. Hereby, the light reducing element LRE is used to seal the meter against optical re-configuration, since its presence hinders use of the optical interface. If placed under a transparent and at the same time a removable part of the casing CS, then the light sensitive component LSC can also detect opening of the casing CS. Hereby, optical sealing can eliminate the need for mechanical seals.

Although the present invention has been described in connection with preferred embodiments, it is not intended to be limited to the specific form set forth herein. Rather, the scope of the present invention is limited only by the accompanying claims.

In this section, certain specific details of the disclosed embodiments are set forth for purposes of explanation rather than limitation, so as to provide a clear and thorough understanding of the present invention. However, it should be understood readily by those skilled in this art, that the present invention may be practised in other embodiments which do not conform exactly to the details set forth herein, without departing significantly from the spirit and scope of this disclosure. Further, in this context, and for the purposes of brevity and clarity, detailed descriptions of well-known apparatus, circuits and methodology have been omitted so as to avoid unnecessary detail and possible confusion.

In the claims, the term "comprising" does not exclude the presence of other elements or steps. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Reference signs are included in the claims however the inclusion of the reference signs is only for clarity reasons and should not be construed as limiting the scope of the claims.

## Claims

1. A consumption meter arranged to measure a consumed quantity of a physical entity, the meter comprising
- a measurement circuit (MC) arranged to perform a measurement of a physical parameter related to the physical entity and to generate measurement data accordingly,
- a calculator circuit arranged to calculate a quantity value representing the consumed quantity in response to the measurement data,
- a casing (CS) housing at least one of the measurement circuit (MC) and the calculator circuit, such as housing both of the measurement circuit (MC) and the calculator circuit, and
- a sealing system arranged in connection with the casing (CS), wherein the sealing system comprises
- a light sensitive component (LSC), such as a photo diode placed behind a transparent part of the casing (CS), and
- a light reducing element (LRE), such as a self-adhesive label, arranged to prevent light incidence on the light sensitive component (LSC), when the light reducing element (LRE) is in a sealing position.

2. Consumption meter according to claim 1, wherein the light sensitive component (LSC) is an optical communication device arranged for communicating with the meter, such as an optical communication device arranged for programming or reading the meter.

3. Consumption meter according to claim 1, wherein the light sensitive component (LSC) is a light sensitive component (LSC) dedicated for sealing purposes, such as a light sensitive component (LSC) arranged in connection with an optical communication device such that the light reducing element (LRE) prevents light incidence on the light sensitive component (LSC) and while leaving the optical communication device un-blocked, when the light reducing element (LRE) is in the sealing position.

4. Consumption meter according to any of the preceding claims, wherein the sealing system comprises an electronic sealing circuit (ESC) connected to the light sensitive component (LSC), and wherein the electronic sealing circuit (ESC) is arranged to detect if the light reducing element (LRE) is in the sealing position, such as the electronic sealing circuit (ESC) being arranged to generate an electric signal accordingly.

5. Consumption meter according to claim 4, wherein the electronic sealing circuit (ESC) is arranged to initiate at least one action in response to detecting that the light reducing element (LRE) is not in the sealing position, such as the meter being an electricity meter comprising a power switch, wherein the at least one action is to switch off the power switch so as to switch off electric supply power to a consumer.

6. Consumption meter according to claim 5, wherein the meter comprises a communication module connected to the electronic sealing circuit (ESC), and wherein at least one action comprises transmitting an external alarm signal by means of the communication module.

7. Consumption meter according to claim 5 or 6, wherein the at least one action comprises storing in a memory data indicating the detection that the light reducing element (LRE) is not in the sealing position, such as storing time and date of such event.

8. Consumption meter according to any of the preceding claims, wherein the light sensitive component (LSC) is placed within the casing (CS), such as behind a transparent cover part of the casing (CS) or in an opening of the casing (CS), and wherein the light reducing element (LRE) is a self-adhesive label arranged to at least partly cover the transparent part of casing (CS).

9. Consumption meter according to any of the preceding claims, wherein the light sensitive component (LSC) is arranged such that it can detect incident light in both of the cases: the light reducing element (LRE) being removed from the sealing position, and the casing (CS) being opened.

10. Consumption meter according to claim 9, wherein the light sensitive component (LSC) is arranged behind a removable cover of the casing (CS), such as behind a transparent part of the removable cover of the casing (CS).

11. Consumption meter according to any of the preceding claims, wherein the sealing system comprises a second light sensitive component arranged inside the casing (CS), such as a photo diode, and wherein at least part of the casing (CS) serves to reduce light incidence on the second light sensitive component, when the casing (CS) is closed.

12. Consumption meter according to any of the preceding claims, wherein the light sensitive component (LSC) is arranged to sense visible light only.

13. Consumption meter according to any of claims 1-11, wherein the light sensitive component (LSC) is arranged to sense light outside a visible light frequency range.

14. Consumption meter according to any of the preceding claims, wherein the light sensitive component (LSC) is a photo diode.

15. Consumption meter according to any of the preceding claims, being one of: an electricity meter, a heat meter, a cooling meter, a water meter, and a gas meter.
